# EUROPEAN PATENT APPLICATION

(11) **EP 0 825 642 A2**
(43) Date of publication of application: **25.02.1998**
(21) Application number: 97305419.0
(22) Date of filing: 18.07.1997
(51) Int. Cl.: H01L 21/311

(54) **Plasma process for high photoresist selectivity and improved polymer adhesion**

(30) Priority: 31.07.1996 US 690035
(71) Applicant: APPLIED MATERIALS, INC., Santa Clara, California 95054-3299 (US)
(72) Inventor: Shi, Shuyun (Tony), Austin, Texas 78749 (US)
(74) Representative: Allard, Susan Joyce

(57) **Abstract**

A plasma etch process for etching a workpiece in a processing chamber of a plasma reactor which produces improved photoresist layer etch uniformity and selectivity, reduced faceting of the photoresist, reduced polymer peeling, and reduced etching of exposed barrier layer surfaces. This improvement is obtained by modifying certain process parameters in a way atypical of current etch processes. Specifically, the chamber pressure and/or flow rate of fluorine-containing components of the etchant gas are increased. In addition, a decrease in the source power used to maintain the plasma or an increase in the roof temperature of the chamber will also contribute to the improvement. To prevent the occurrence of significant etch stopping, a diluent is added to the etchant gas to limit the formation of polymer. The addition of a diluent works well up to a point, after which the combined effect of modifying the aforementioned process parameters causes etch stopping regardless of the amount of diluent gas flowing through the chamber. Therefore, values chosen for the four process parameters are coordinated to optimize the benefits of the present invention, while minimizing etch stopping.

## Description

The invention is related generally to a method for etching semiconductor integrated circuit wafers in a plasma reactor, and specifically to improvements in the etch uniformity and selectivity of a photoresist layer as well as polymer adhesion to this layer.

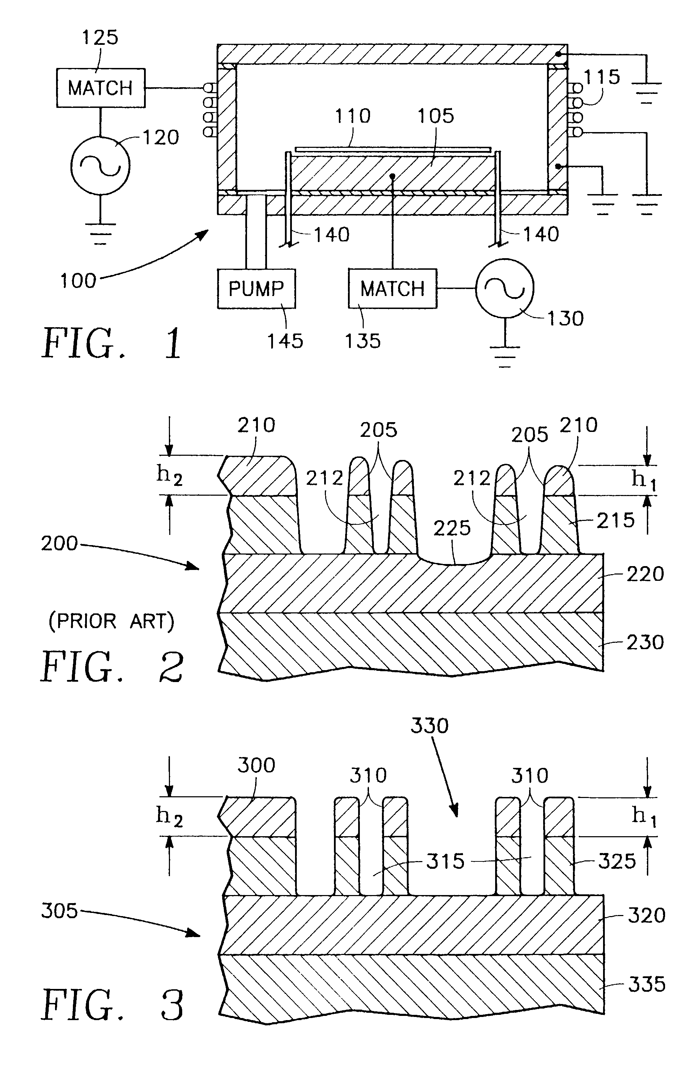

In a plasma etch reactor for processing semiconductor integrated circuit wafers, a typical etch process includes the introduction of an etchant gas such as ethyl hexafluoride (C2F6) into a vacuum chamber. Such an etch process using C2F6 often employs an inductively coupled plasma reactor, such as the type shown in FIG. 1. The reactor includes a vacuum chamber 100 and a wafer pedestal 105 for supporting a semiconductor wafer or workpiece 110. An inductive coil antenna 115 is wound around the sides of the chamber 100 and connected to a radio frequency (RF) plasma source power generator 120 through an impedance match circuit 125 to provide RF power into the chamber. A bias RF power generator 130 and associated impedance matching circuit 135 imposes a RF bias on the wafer 110. Etchant gas is introduced into the chamber 100 through an annular manifold having plural gas injection ports 140. A vacuum pump 145 evacuates the chamber 100 to a desired chamber pressure.

Etching of wafers using C2F6 as an etchant, in a reactor such as shown in FIG. 1, is performed at relatively low pressures, typically less than 10 millitorr, and low etchant flow rates, typically less than 40 sccm. These low pressures and flow rates are necessary to avoid over-polymerization and etch stopping, as will be explained later.

In operation, the plasma power source 120 generates a plasma by creating an electromagnetic field which breaks down the molecules of the gases in the chamber to form a plasma. The plasma causes the etchant gas to produce etchant species which are used to etch the wafer 110. These species include, for example, fluorocarbon ions and radicals, and free fluorine ions and radicals. Molecular or atomic carbon is also generated by the plasma interaction, which combines with some of the fluorocarbon radicals to form polymers that adhere to the exposed surfaces of the wafer. Polymers forming on oxygen-free layer of the wafer are resistant to etching.

This polymerization process is advantageously employed in a typical oxide layer etch process to, among other things, block or reduce the etching of an oxygen-free layer (e.g. a barrier layer made of materials such as silicon, titanium nitride or titanium silicide) underlying an oxide layer (e.g. silicon dioxide) being etched. Inhibiting the etching of an underlying oxygen-free layer facilitates the formation of features, such as holes (referred to herein as "contact vias") or trenches, through the silicon dioxide, without damaging the underlying oxygen-free layer.

The polymerization process will now be explained using the example of a silicon barrier layer with an overlying silicon oxide layer which is to be etched.

During plasma etching, oxygen is freed from the silicon dioxide layer as this layer is etched. The oxygen is released by the reduction of silicon dioxide by the etchant species, such as ions formed in the plasma. These ions are typically drawn to the wafer by the aforementioned RF wafer bias. The released oxygen reacts with the polymer that has formed on the oxide layer, causing it to be etched away. However, when the contact via or trench becomes deep enough to expose the underlying silicon layer, a polymer film forms over this layer. Since no oxygen is present in the silicon layer, the polymer remains intact and protects the underlying layer from being etched.

The critical dimension, or "CD" (i.e. the diameter of a contact via, or width of a trench), is maintained because a thin layer of polymer forms on the side walls of the feature and is never completely etched away. The thin film on the side walls survives because the trajectory of the etching ions is predominantly perpendicular to the surface of the wafer. Thus, the ions only sideswipe the walls. As a result, the polymer layer forming on the side walls of an etch feature does not build up significantly due to the chopping action of the ions, but it is not completely removed either. This leaves the side walls substantially intact. However, the ions directly impact on the bottom of the etch feature. This bombardment impairs the formation of polymer on the bottom of the feature, and etches the silicon dioxide causing the feature to become increasing deeper.

The rate at which silicon dioxide is removed at the bottom of an etch feature depends on many factors, including the number of impacting ions and their momentum, as well as the local chemistry at the bottom of the feature. The aforementioned etching of the forming polymer layer by the oxygen released from the silicon dioxide is primarily a chemical reaction which produces by-products. If the concentration of these by-products gets too great, a significant decrease in the etching of the silicon dioxide occurs. This, in turn, reduces the release of oxygen and so upsets the balance between the deposition and removal of the polymer. Consequently, the polymer builds up, thereby preventing any further etching of the underlying silicon dioxide at the bottom of the etch feature. In such a case, no matter how long the etching process (i.e. ion bombardment) is continued, no more depth can be obtained. This phenomenon is referred to as etch stopping. The aforementioned build up of by-products is affected by several factors. For example, the greater the pressure and/or etchant flow rate in the chamber, the faster the buildup of silicon dioxide etch by-products. In addition, the depth and size of the critical dimension of an etch feature play a key role. For example, a deeper etch feature and/or smaller CD causes the etch by-products to accumulate more easily.

Maintaining the proper balance between polymer formation and etching from the bottom of an etch feature in the silicon dioxide layer, in order to achieve substantial etch depths, has previously meant performing the etching process at relatively low pressures and etchant flow rates. If the process were performed at higher pressures and/or etchant flow rates, an etch stop condition would result. As discussed above, a higher pressure or etchant flow rate affects the build-up polymer etchant by-products. In addition, these conditions also cause an increase in concentration of polymer forming radicals in the plasma, in comparison to the concentration of etching ions. A higher concentration of radicals in the plasma, coupled with a lower concentration of ions, upsets the balance between the deposition and etching of polymer on the bottom etch features in the oxide layer. This, in conjunction with the concurrent build-up of polymer etch by-products, causes polymer to accumulate on the bottom of an etch feature. Thus, an etch stop condition is created.

Another function of the polymerization process is to protect the photoresist layer which masks those portions of the silicon dioxide layer which are not to be etched. Photoresist materials, such as Novolac resins, will etch at a slower rate than silicon dioxide. However, the selectivity of typical etchants for the photoresist layer without a protective polymer coating is not typically high enough in comparison to the silicon dioxide to protect it throughout the etch process. This selectivity refers to the degree to which an etchant etches a specified layer. Low selectivity means that the etchant will remove the specified layer at a rate close to that of another layer, whereas high selectivity means that the etchant will remove the layer at a much slower rate than another layer. For example, when etching a silicon dioxide layer, the etchant has a high selectivity for the underlying silicon layer once the protective polymer coating has formed, in comparison to the silicon dioxide. When it is stated above that the selectivity for the photoresist material alone was not high enough, it was meant that at least portions of the layer would typically be etched away in the absence of an adequate deposition of polymer before the etching of the exposed portions of the silicon dioxide layer is complete. This being the case, an unwanted etching of the silicon dioxide layer underlying the removed portions of the photoresist layer occurs. If this unwanted etching of the silicon dioxide layer occurs at the edge of one of the etch features being formed, the feature's CD could be adversely affected. This is referred to as faceting. If, on the other hand, polymer is deposited over the photoresist layer, unwanted etching is significantly reduced or eliminated. As a result, the effective selectivity of the etchant for the photoresist layer is increased. If the selectivity is increased enough, the etching of the silicon dioxide layer can be completed before any of the aforementioned unwanted etching results. Thus, it is preferable to have an etch process that is highly selective to the photoresist layer at all points on the surface of the wafer.

A known problem associated with current etch processes is a non-uniformity in the etch rate of the photoresist layer from the outer edge to the center of the wafer. Specifically, photoresist materials used in a wafer masking processes, although etching at a slower rate than the exposed portions of the silicon dioxide layer due to the high selectivity of the photoresist, tend to be etched more quickly near the edge of the wafer than at its center. This effect is shown in FIG. 2 by comparing a height h₁ of the photoresist layer 210 covering a feature near the edge of a wafer 200 with the height h2 of the photoresist layer 210 covering a feature closer to the center of the wafer 200. The skewed etch profile can cause the photoresist masks over the portions of the silicon dioxide layer near the edge of the wafer to be depleted, resulting in unwanted etching and damage to the underlying layer.

In addition, it has been observed that the portion of the photoresist layer bordering features, near the edge of the wafer exhibit an even higher etch rate (i.e. lower selectivity). For example, etchant ions produce the aforementioned faceting on the photoresist adjacent the feature, as shown in FIG. 2 by facets 205 in a photoresist layer 210. This faceting results in a loss of CD control of the feature. For example, the width of trenches 210 in a silicon dioxide layer 215 expands at the top between portions of the photoresist layer 210 exhibiting faceting. The faceting effect has been found to be even more pronounced for etch features that are closely grouped, i.e. a "dense area", such as one having spacings of less than about 1 µm.

It has also been observed that a barrier layer, such as one made of titanium silicide (TiSi) and titanium nitride (TiN), formed as part of large features near the edge of a wafer may be excessively etched, once the overlying silicon dioxide layer has been removed. For example, in reference to FIG. 2, features with large dimensions such as bondpads (on the order of 10 µm) and trenches (with lengths of 10 - 100 µm) frequently result in etching of a depression 225 in the barrier layer 220 when current etch processes are employed. This may even lead to an unwanted punchthrough of the barrier layer 220 to the underlying substrate 230 should the depression 225 become deep enough.

Another limitation of current etch processes is that the polymers formed on the photoresist tend to peel off after the etch process, primarily in areas near the center of the wafer. This behavior is pronounced at higher plasma source powers (over 2800 watts), lower etchant flow rates (35 sccm), and at longer etch times (exceeding 180 seconds). The problem appears to be caused by internal stresses created in the polymer layer as it is formed. These internal stresses led to fractures and then flaking of polymer from the wafer's surface. One solution has been an in-situ removal of the polymer by introducing oxygen into the plasma, which etches the polymer so that it is removed from the chamber along with the other exhaust gases. If the polymer is not removed in this manner, it can peel from the photoresist and fall on the chamber floor causing contamination that must be removed by cleaning the chamber. Either the in-situ removal or frequent cleaning of the chamber to remove peeled polymer is undesirable as such procedures are both costly and time consuming.

It is believed the aforementioned photoresist layer problems are caused in part by the release of oxygen from the plasma reactor's chamber wall near the periphery of the wafer during etch operations, and in part by the high fluorine content of the polymer-forming radical produced in the portion of the plasma overlying the periphery of the wafer. Typically, the side walls of the chamber are composed of oxygen-bearing materials (e.g. silicon dioxide in the form of quartz) which are etched during the etching procedure, thereby releasing oxygen.

Additionally, the etchant gas is typically introduced from the sides of the chamber and so enters the plasma in the region overlying the periphery of the wafer. Once in the plasma, the etchant gas disassociates into various etch species including fluorine-containing radicals which combine with other plasma species to form the polymer. However, it is believed that the polymer-forming radicals created in the region of the plasma overlying the periphery of the wafer have a higher fraction of fluorine that those forming in the central region of the plasma due to the etchant gas being first introduced in the peripheral region.

It is theorized that the combined presence of the oxygen and the polymer-forming radicals with higher fluorine content in the areas overlying the edge of the wafer cause the higher photoresist etch rates adjacent the wafer's periphery. The oxygen present in the reactor chamber near the periphery of the wafer probably interferes with the deposition of polymer onto the wafer surfaces in this area. In addition, the polymer that does form on the peripheral region of the wafer has a higher fraction of fluorine. Polymers with high fluorine content are removed from the photoresist at a faster rate that polymers having low fluorine content. The net result is that the photoresist layer formed at the periphery of the wafer etches at a faster rate than at the central portion of the wafer. This increased etching of the photoresist layer at the wafer's periphery explains the previously-described non-uniformity in the photoresist layer etch rate, and so the lower selectivity of the etchant at the wafer's periphery. In addition, it is believed this increased photoresist layer etching at the wafers edge also causes the faceting problem, as well as the aforementioned problem associated with excessive etching of the barrier layer.

It is an object of the present invention to provide an improved etch process exhibiting good photoresist etch uniformity and high selectivity for the photoresist layer. In this way, faceting of the photoresist layer at the periphery of the wafer is substantially reduced or prevented.

It is another object of the invention to eliminate the peeling or flaking of the polymer from the surface of the photoresist layer after etching in order to prevent contamination of the chamber.

It is still another object to eliminate the formation of unwanted depressions in the barrier layer at the periphery of the wafer.

The present invention is embodied in a plasma etch process for etching a workpiece, such as a semiconductor wafer, in a processing chamber of a plasma reactor. This process produces certain desired characteristics such as improved photoresist layer etch uniformity and selectivity, reduced faceting of the photoresist at the edge of an etch feature on the workpiece, reduced polymer peeling, and reduced etching of exposed barrier layer surfaces. In general, this improvement is obtained by an increase in the chamber pressure and/or flow rate of fluorine-containing components of the etchant gas used in the etching process. It is theorized that these benefits result from an increase in the radical-to-ion species ratio of the plasma overlying the wafer, created by the increased pressure and/or etchant flow rate. To a smaller extent, a decrease in the source power used to maintain the plasma will also increase the radical-to-ion ratio. In addition, an increase in the chamber roof temperature will cause a concentration of the polymer-forming radicals in the portion of the plasma adjacent the wafer. This has the effect of increasing the radical-to-ion ratio in that portion of the plasma, thereby producing the aforementioned desired characteristics.

An increased radical-to-ion ratio can upset the desired balance between the deposition and etching of polymer on the bottom of etch features, thereby causing an etch stop condition. To reduce etch stopping, a diluent gas is added to the etchant gas. The addition of a diluent works well up to a point, but the combined effect the chamber pressure, fluorine-containing etchant component flow rate, source power and roof temperature can produce a radical-to-ion ratio which causes etch stopping regardless of the amount of diluent gas flowing through the chamber. Therefore, the aforementioned four process parameters are preferably coordinated to optimize the benefits of the present invention, while minimizing etch stopping.

A preferred method of performing the plasma etch process according to the present invention, which includes the coordination of the aforementioned four process parameters, begins with igniting a plasma within the chamber, and then introducing a fluorine-containing component of an etchant gas into the chamber. This fluorine-containing component is either a fluorocarbon gas or a hydrofluorocarbon gas, or both. Next, the diluent component of the etchant gas is introduced into the chamber. Preferably, this diluent component is an inert gas. The coordination of the four process parameters (i.e. (i) the flow rate of the fluorine-containing component, (ii) the chamber pressure, (iii) the power level of the power source, and (iv) the temperature of the chamber roof), includes fixing respective values of three of these process parameters. Then, the value of the remaining parameter is incrementally varied until a test workpiece placed into the chamber exhibits the desired characteristics. If the desired characteristics are not exhibited regardless of the value chosen for the remaining process parameter, the value of at least one of the three fixed process parameters is modified. The modified value is then fixed, and the step of incrementally varying the value of a remaining process parameter is repeated.

However, it is preferred that the remaining process parameter be either the flow rate of the fluorine-containing component, the chamber pressure, or the source power. Specifically, if it is desired to maximize the photoresist etch uniformity and selectivity, then either the flow rate or the pressure should be chosen as the variable parameter. However, if instead the maximization of the etch depth is desired, then either the flow rate or the source power should be chosen as the variable parameter.

Once the coordination procedure is complete, a production workpiece is placed into the chamber. The same fluorine-containing component of an etchant gas is again introduced into the chamber, along with a diluent component. Finally, the plasma etch process is performed using the fixed values of the chosen process parameters and the value of the remaining process parameter which was determined to cause the desired characteristics to be exhibited.

It has been found that the type of the fluorine-containing gas employed has an effect on the degree to which the desired characteristics are obtainable, as well as the maximum etch depth. Specifically, it has been found that the use of a fluorocarbon gas, such as C2F6, can produce substantial etch depths but only a moderate improvement in photoresist etch rate uniformity and selectivity. Whereas, it was found that a hydrofluorocarbon gas, such as CHF₃, can result in a substantial improvement in the photoresist etch rate uniformity and selectivity, but a limited etch depth. A combination of fluorocarbon and hydrofluorocarbon gas results in a good photoresist etch rate uniformity/ selectivity and etch depth, but not as good an etch rate uniformity/selectivity as could be obtained using just a hydrofluorocarbon gas, and not as good an etch depth as could be obtained using just a fluorocarbon gas alone. In view of this, an alternate two-step method is preferred when optimum results are desired. Essentially, the alternate process involves introducing the fluorocarbon and hydrofluorocarbon gases separately. Specifically, the alternate process includes introducing the workpiece into the chamber, igniting a plasma within the chamber, flowing in a hydrofluorocarbon component of an etchant gas, and flowing in a diluent component of the etchant gas. An initial etching of the workpiece is then performed. Once complete, the flow of the a hydrofluorocarbon component is stopped, and a fluorocarbon component of an etchant gas is introduced into the chamber to complete the etching process.

As with the first method, this alternate method could also include a coordination of the previously-described four process parameters using test workpieces prior to the etching of a production workpiece.

FIG. 1 is a cross-sectional view of a plasma reactor showing a gas introduction port.

FIG. 2 is a cross-sectional view of a portion of a semiconductor wafer after etching using a prior art etching process.

FIG. 3 is a cross-sectional view of a portion of a semiconductor wafer after etching using an etching process of the invention.

FIG. 4 is a flow diagram illustrating a coordination procedure in accordance with the present invention for coordinating the setting of certain etch process parameters.

FIG. 5 is a flow diagram illustrating an alternate multi-step etch process in accordance with the present invention.

FIG. 6 is a cross-sectional view of a portion of a semiconductor wafer having an anti-reflective coating after etching using an etching process of the invention.

In the following description of the preferred embodiments of the present invention, reference is made to the acccmpanying drawings which form a part hereof, and in which is shown by way of illustration specific embodiments in which the invention may be practiced. It is understood that other embodiments may be utilized without departing from the scope of the present invention. The preferred embodiments of the present invention will be described in connection with their use in an inductively-coupled plasma reactor, such as the one shown in FIG. 1. However, the process of the present invention is not limited to the use of an inductively-coupled reactor. Rather, any existing plasma etch reactor can be employed. For example, a capacitively-coupled or ECR-type plasma etch reactor could be successfully adapted to perform the preferred method of the invention. However, the present invention also involves adjusting etch process parameters, such as the reactor chamber pressure and etchant flow rate, within certain limits. Accordingly, any etch reactor used must be capable of producing specified process parameter changes, as required.

In a first preferred embodiment of the present invention, the traditional C₂F₆ etchant gas is replaced with a mixture of C₂F₆ and a diluent gas. The diluent gas is defined for the purposes of the present invention as an inert gas, i.e. one which is not chemically reactive in respect to (i) a semiconductor wafer undergoing processing within the reactor chamber, and (ii) particles within the plasma, such as etchant ions and radicals. Specifically, it is preferred that the diluent gas be a nobel gas, such as helium or argon. A second preferred embodiment replaces the C₂F₆ with a mixture of trifluoromethane (CHF₃)and the diluent gas. A third preferred embodiment employs a mixture of C₂F₆ and CHF₃ along with the diluent as the etchant gas. And, a fourth preferred embodiment uses a two-step approach where the workpiece is first etched using a mixture of CHF₃ and the diluent gas, followed by a final etch step employing C₂F₆ and the diluent as the etchant.

Although the preferred embodiments of the present invention, and as will be discussed later the tested embodiments as well, employ the specific fluorine-containing etchant components described above, it is not intended that the invention be limited to these specific components. For example, it is believed any fluorocarbon gas currently being used as an etchant could be employed as a substitute for C₂F₆ with satisfactory results. In particular, it is believed that carbon tetrafluoride CF₄ would make a suitable substitute. In addition, it is believed that any hydrofluorocarbon gas typically used as an etchant could serve as a substitute for CHF₃. Specifically, monofluoromethane (CH₃F) is thought to be a suitable substitute.

In all the above embodiments, the chamber pressure and/or etchant flow rate is increased over the maximum pressure and flow rate (i.e. 10 millitorr and 40 sccm) associated with a traditional etch process using C₂F₆ alone as the etchant gas. Preferably, the chamber pressure associated with the etch process of the present invention will be within a range from about 4 millitorr to about 60 millitorr. It is also preferred that, while maintaining the chosen pressure, the cumulative flow rate of fluorine-containing components is within a range from about 15 sccm to about 80 sccm. However, the particular combination of values chosen for the pressure and etchant flow rate must be restricted. Essentially, the combination of pressure and flow rate values is preferably chosen such that the radical-to-ion ratio of the plasma maintains the desired balance between the deposition and removal of polymer on the bottom of the etch features being formed in a silicon dioxide layer. Maintaining such a balance reduces the occurrence of an etch stop condition.

As for the diluent gas component of the etchant, the preferred flow rate is from about 50 sccm to about 400 sccm in all embodiments. However, the maximum diluent flow rate is preferably no more than about five to ten times the combined flow rate of all fluorine-containing components of the etchant gas, and the minimum diluent flow rate is preferably no less than about one-half this combined flow rate. For example, if the flow rate of all the fluorine-containing etchant gas components is 40 sccm, the preferred diluent flow rate would be no more than about 200 to 400 sccm, and no less than about 20 sccm. It is believed significantly exceeding the ten-times limit would reduce the benefits imparted by the addition of the diluent gas.

Before discussing the particular advantages associated with each etchant gas mixture, the overall advantage of increasing the chamber pressure and/or the flow rate of the fluorine-containing etchant gas components, as well as including a diluent gas, will be explained.

As described previously, increasing the chamber pressure results in a higher ratio of radicals-to-ions in the plasma. Similarly, increasing the flow rate of the fluorine-containing components of the etchant gas causes a higher radical-to-ion ratio in the plasma at any given time. The increased ratio has a beneficial effect in that it is believed the increased concentration of radicals somehow mitigates the impact of the oxygen released by the etching of the pedestal and chamber side walls on polymer formation over the photoresist layer at the peripheral surfaces of the wafer. In addition, it is theorized that the increased radical-to-ion ratio increases the polymer deposition rate and tends to smooth out the non-uniformity in the fluorine content of the polymer-forming radicals within the plasma. Accordingly, not only is more polymer deposited on the photoresist layer at the periphery of the wafer, but it is believed the polymer that forms will have substantially the same fraction of fluorine as polymer formed elsewhere on the wafer. The net result of this is a more uniform etching of the photoresist across the surface of the wafer, as well as a higher selectivity for the photoresist layer at the periphery of the wafer.

FIG. 3 illustrates the improvement obtained using the preferred embodiments of the present invention after any polymer formed on the wafer during etching has been removed. The height h₁ of the portion of a photoresist layer 300 covering parts of the wafer 305 near its edge is now virtually the same as the height h₂ of the portion of the photoresist layer 300 covering parts of the wafer 305 closer to its center. The faceting of the photoresist layer at the edge of etch features near the periphery of the wafer is also reduce in comparison to a typical prior art etch processes. As shown in FIG. 3, the portions 310 of photoresist masking the oxide layer 325, do not exhibit faceting and features 315 exhibit good CD control (i.e. parallel sides).

The diluent gas also produces advantageous results. Specifically, the presence of the diluent gas in the plasma appears to cause the polymer to form on the wafer with fewer internal stresses. Accordingly, the polymer layer is less susceptible to stress fracturing, thereby decreasing the flaking of the polymer from the photoresist layer after the etching process is complete. The addition of the diluent gas during testing of the preferred embodiments of the present invention resulted in the virtual elimination of problem of polymer peeling from the wafer. No significant contamination of the reactor chamber by polymer debris was observed during this testing.

The excessive etching of the exposed barrier layer in the peripheral region of the wafer, which caused unwanted depressions, is also reduced dramatically. Again, this is believed to be the result of an improved rate of polymer deposition on the barrier surface due to the increased radical-to-ion ratio of the plasma. As depicted in FIG. 3, the etch of a silicon dioxide layer 325 exhibits a high selectivity to the barrier layer 320. Thus, the surface of the barrier layer 320 exposed by the etching of a large trench 330 near the edge of a wafer 305 is flat and devoid of unwanted depressions. Accordingly, any possibility of punchthrough to the underlying substrate 335 is eliminated.

The dramatic improvements described above, however, cannot be derived by increasing the chamber pressure and/or etchant flow rate alone. Since a higher concentration of the polymer-forming radicals in comparison to the polymer-etching ions exist within the chamber at an increased chamber pressure, and/or fluorine-containing etchant component flow rate, the opportunity to form polymer increases. A resulting increase in the deposition of polymer on the photoresist and barrier layer surfaces reduces the etching thereof and increase the selectivity of the etchant for these surfaces. However, any increased polymer deposition would also effect the exposed portions of the oxide layer which are being etched. At some point the increase in polymer deposition will upset the balance between the formation and etching of polymer on the bottom of etch features, thus causing an etch stop condition. This potential problem is lessened by the addition of the diluent (e.g. helium and/or argon) to the etchant gas. The diluent acts to inhibit the formation of polymer. It has been found the addition of the diluent gas at a flow rate within the aforementioned preferred range can substantially maintain the balance between the formation and etching of the polymer at the bottom of the etch features, even though the chamber pressure, and/or flow rate of the fluorine-containing etchant gas components has been increased. The flow rate of the diluent is preferably chosen such that the polymer formation is limited to that which will substantially maintain the balance of polymer deposition and etching on the bottom of the etch features. The exact value of the diluent flow rate which will maintain the desired balance will vary depending on the particular reactor and the other process parameters employed to perform the etching process. The appropriate value can be readily determined by one skilled in the art using well known testing methods. However, it is preferred that the maximum flow rate of the diluent gas not exceed about five to ten times the combined flow rate of all fluorine-containing components of the etchant gas. If the diluent flow rate significantly exceeds the ten-times upper limit it is believed its beneficial effects would be degraded.

The addition of the diluent gas is believed to provide other benefits as well. For example, it is theorized that the additional ions produced in the plasma from the diluent gas may enhance the etching of the exposed portions of the oxide layer.

Even though the addition of a diluent to the etchant gas allows the use of higher chamber pressures and/or fluorine-containing etchant component flow rates, there is a limit beyond which the diluent will be ineffective in this regard. Specifically, the increase in the ratio of radical-to-ion ratio in the plasma caused by the increased pressure and/or flow rate will eventually create an unacceptable etch stop condition somewhere on the surface of the wafer, no matter what flow rate has been chosen for the diluent. Accordingly, the values chosen for the chamber pressure and fluorine-containing component flow rate must be limited to levels which will not create significant etch stopping.

It has also been found that certain other process parameters have an effect on the effective radical-to-ion ratio of the plasma above the wafer. Namely, the source power used to maintain the plasma and the temperature of the reactor chamber's roof or ceiling. Preferably, the source power associated with the etch process of the present invention will be within a range from about 1200 watts to about 3000 watts, and the roof temperature within a range from about 180 °C and about 300 °C. A decrease in the source power causes a general increase in the radical-to-ion ratio throughout the plasma. However, increasing the roof temperature only causes a localized increase in the radical-to-ion ratio in the portion of the plasma directly overlying the wafer. This localization results because the increase in roof temperature has the effect of driving radicals toward the cooler wafer surface. Thus, only the area of the plasma directly over the wafer exhibits the increases radical-to-ion ratio. It is noted, however, that the effective change in the ratio caused by adjusting the source power or roof temperature are not as profound as the change caused by adjusting the chamber pressure or fluorine-containing component flow rate. Thus, while the source power and roof temperature levels must be considered in order to optimize the benefits afforded by a higher radical-to-ion ratio (without creating a significant etch stop condition), they can not be relied upon by themselves to achieve this higher ratio. Rather, it is the increase in the chamber pressure and/or flow rate of the fluorine-containing etchant components which is substantially responsible for raising the radical-to-ion ratio to a level where the benefits can be realized.

Summarizing the foregoing discussion, an increase in the chamber pressure and/or flow rate of the fluorine-containing components of the etchant gas within the disclosed limits will produce a more uniform etching of the photoresist layer, reduce faceting of the photoresist, and reduce the excessive etching of exposed barrier layer surfaces. It is theorized that these benefits result from an increase in the radical-to-ion ratio of the plasma caused by the increased pressure and/or etchant flow rate. In addition, to a smaller extent, a decrease in the source power or an increase in the roof temperature will also increase the radical-to-ion ratio. However, the increased ratio also can upset the desired balance between the deposition and etching of polymer on the bottom of the etch features, thereby causing an etch stop condition. To reduce etch stopping, a diluent is added to the etchant gas to limit the formation of polymer in the plasma. The addition of this diluent gas also seems to reduce the internal stress in the polymer formed on the wafer, and so reduces polymer peeling. However, in regards to the limiting of polymer formation, the diluent works well only up to a point. The combined effect the chamber pressure, fluorine-containing etchant component flow rate, source power and roof temperature can produce a radical-to-ion ratio of the plasma which causes etch stopping regardless of the amount of diluent gas flowing through the chamber. Therefore, these four process parameters are preferably coordinated to optimize the benefits of the present invention, while minimizing etch stopping.

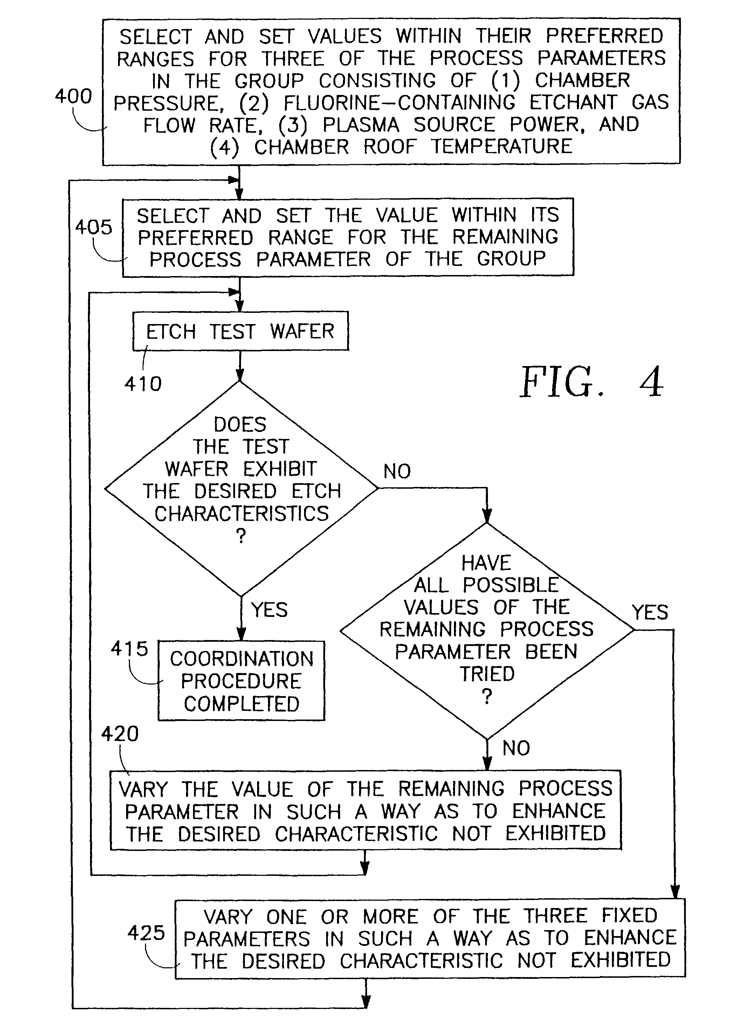

A preferred method in accordance with the present invention for coordinating the chamber pressure, fluorine-containing etchant component flow rate, source power and roof temperature is shown in FIG. 4. In step 400, values of three of the four process parameters are selected and set (within their respective preferred ranges). Next, in step 405 the value of the remaining parameter is selected and set (again within its preferred range). A test wafer or workpiece is then etched in step 410 according to the methods of the present invention. If the aforementioned desired characteristics are observed in the test wafer, and at the same time the desired etch depth is obtained, the coordination procedure is complete and production wafers or workpieces can be processed (step 415) using the selected values. If, on the other hand, the desired characteristics are not observed or an etch stop condition occurred, the remaining parameter is increased or decreased in a way which will enhance the characteristics not exhibited or prevent the etch stopping condition (whichever applies), as illustrated in step 420. The test wafer etching step (410) is then repeated along with the appropriate subsequent steps. If all the possible values of the remaining parameter are tried, but do not produce the desired results, then the value of one or more of the first three parameters is increased or decreased as appropriate to alleviate the problem (step 425). The step 405 involving the selection and setting of the remaining parameter is then repeated, as well as the appropriate subsequent steps.

It is preferred that the remaining process parameter associated with the foregoing method be either the chamber pressure, the flow rate of the fluorine-containing etchant gas components, or the source power depending on the particular attribute which is desired to be enhanced. For example, it has been found that pressure and flow rate have the most profound effect on the resulting photoresist etch uniformity and selectivity. Thus, for producing the highest photoresist etch uniformity and selectivity, one of these parameters should be chosen as the variable parameter. However, it has been observed that the flow rate and the source power have the most profound effect on the etch depth obtained. Thus, one of these parameter should be chosen if the etch depth is desired to be maximized. Of course, since the fluorine-containing etchant flow rate is common to both categories of desired results, this parameter would preferably be employed as the variable absent any other considerations.

The particular attributes associated with each etchant gas mixture of the preferred embodiments of the invention will now be described using a series of tables. The tables summarize the process parameters and gas mixtures that were examined for each embodiment. It is noted that the source power and roof temperature were essentially fixed in the following examples, while different chamber pressures and fluorine-containing etchant gas component flow rates were tried in an attempt to identify the optimum benefits obtainable with each of the etchant mixtures employed.

**TABLE 1**

| **RUN** | **C**_{**2**}**F**_{**6**} **(sccm)** | **He (sccm)** | **Pressure (mT)** | **Results** |
|---|---|---|---|---|
| **1-1** | 26 | - | 1.56 | U&S - Poor Peeling |
| **1-2** | 26 | - | 6.50 | U&S - Poor Peeling |
| **1-3** | 26 | 100 | 6.15 | U&S - Poor |
| **1-4** | 40 | - | 30.00 | U&S - Fair Etch Stop |
| **1-5** | 40 | 100 | 30.00 | U&S - Fair |

Table 1 summarizes the chamber pressure and flow rates of etchant gas components associated with the first preferred embodiment of the present invention where a mixture of C2F6 and a diluent gas (e.g. helium or argon) is employed. It is noted that runs 1-2 through 1-4 represent variations of the first embodiment, whereas 1-1 exemplifies the parameters typically employed in prior etching processes. The other process parameters used in combination with the conditions and mixtures identified in Table 1 include a source power of about 2600 for runs 1-1 and 1-2, and 2900 watts for runs 1-3 and 1-4. In addition, a RF bias power of about 1500-1600 watts was used. The roof temperature was set at 270 °C. The wall temperature was generally set at 220 °C, but it is believed a variation in a range of from 180 to 240 °C would have no adverse effects. In each case the frequency of the applied RF energy was 2.0 MHz for the source power and 1.8 MHz for the RF bias power. The etch time was approximately 160 seconds. However, depending on the desired etch depth, the process of the invention could be used for etch times in the range of 30 to 180 seconds. In addition to the chamber pressure and flow rates of etchant gas components, Table 1 includes a results column. These results refer to the observed uniformity of the photoresist layer etching (U) and the selectivity for the photoresist at the periphery of the wafer (S). The etch uniformity and selectivity was rated either poor, fair, good, or best. Any adverse conditions that were observed, such as polymer peeling (peeling) or etch stopping, are also noted in the results column.

Run 1-1 in Table 1, which employed the typical prior art etchant gas consisting solely of C₂F₆ and the typical etch conditions, exhibited a high degree of non-uniformity in the photoresist etch rate across the surface of the test wafer and poor selectivity at the wafer's periphery, as well as the peeling of polymer deposits from the photoresist layer.

The chamber pressure was increased to about 6 mT in Run 1-2 and a slight improvement in the etch uniformity and selectivity was observed, although it was still considered poor. Polymer peeling was also present. However, with the addition of diluent gas (i.e. helium) in run 1-3 the polymer peeling problem was substantially eliminated (although the uniformity and selectivity remained poor). This shows that it is the addition of the diluent which resolves the polymer peeling problem.

It is noted that in runs 1-2 and 1-3, the flow rate of the C₂F₆ and the chamber pressure were kept well below the maximum limits described previously. However, in run 1-4, the combined values for the chamber pressure and C₂F₆ flow rate were increased (i.e. a pressure of about 30 millitorr and a flow rate of about 40 sccm). The higher pressure and flow rate resulted in a further improvement in the photoresist etch rate uniformity and selectivity, but exhibited reduced etching of features due to an unacceptable etch stop condition and polymer peeling. The etch stopping and polymer peeling were expected because no diluent component was added to the etchant gas. The addition of a diluent component (i.e. helium) in run 1-5 cured the etch stopping condition and eliminated the polymer peeling, while maintaining the improvement in the etch rate uniformity and selectivity.

Although the increased pressure and flow rates associated with runs 1-4 and 1-5 produced a more uniform photoresist etch rate and higher selectivity of the etchant for the photoresist layer, it was also observed that the direct current (DC) chucking bias imposed on the wafer was reduced. Typically, a DC bias is imposed on the wafer in reactors employing a monopolar electromagnetic chuck as a pedestal. The DC bias acts to hold the wafer on the pedestal. Some reactors also have a wafer cooling system which results in a gas pressure being applied to the bottom surface of the wafer. In these systems, the DC wafer bias is additionally used to hold the wafer down onto the pedestal against the upward force created by the cooling gas. It is believed that the effect that the increased pressure produced in the plasma caused the decrease in the DC bias imposed on the wafer. A lowering of the DC bias imposed on the wafer could result in the wafer being dislodged from the pedestal by the force of the aforementioned cooling gas. Therefore, it may not be practical to employ pressure and flow rate values which would produce the optimum benefits of the present invention when using the first embodiment. Rather, somewhat lower values may have to be employed, such as those used in run employing the run 1-2, in order to minimize the effect on the DC wafer bias. However, these of lower values come at the cost of less improvement in the photoresist etch rate uniformity and selectivity.

The aforementioned problem could be resolved by increasing the DC bias imposed on the wafer to compensate for the aforementioned counteracting effect. However, the increase in the power necessary to produce this increased DC bias may be beyond the capability of some commercially available etch reactors. Thus, at least in the case of these reactors, an optimum etch uniformity may not be obtainable when employing this first embodiment of the present invention.

**TABLE 2**

| **RUN** | **CHF**_{**3**} **(sccm)** | **He (sccm)** | **Pressure (mT)** | **Results** |
|---|---|---|---|---|
| **2-1** | 40 | 100 | 6.18 | U&S - Fair |
| **2-2** | 40 | 100 | 30.00 | U&S - Good |
| **2-3** | 58 | 100 | 60.00 | U&S - Good Etch Stop |
| **2-4** | 58 | 200 | 60.00 | U&S - Good Etch Stop |

Table 2 summarizes the tested chamber pressure and flow rates of etchant gas components associated with the second preferred embodiment of the present invention where a mixture of CHF3 and a diluent gas (e.g. helium or argon) is employed. The other process parameters used in combination with the conditions and mixtures identified in Table 2 were similar to those employed for Table 1, except that a source power of 2900 watts was used for all runs. In addition, a results column is included similar to the one presented in Table 1.

The runs 2-1 and 2-2 in Table 2 demonstrate the improvements resulting from substituting CHF₃ for C₂F₆ and increasing the chamber pressure. In run 2-1, photoresist etch uniformity and selectivity was observed to improve in comparison to using C₂F₆ as the etchant gas at the conditions specified for run 1-1 in Table 1. In addition, no polymer peeling occurred. Although, the flow rate of CHF₃ was somewhat higher (i.e. 40 sccm) than the C₂F₆ (i.e. 26 sccm), it is believed the photoresist etch rate uniformity and selectivity using the CHF₃ would still be better. This belief is based on a theory that more polymer-producing etchant radicals are created from the dissociation of CHF₃ in the plasma and that these radicals are more evenly distributed in the plasma, than corresponding radicals created from C₂F₆. The more numerous and evenly distributed radicals produced from the CHF₃ results in a thicker and more even deposition of polymer on the photoresist layer, and so a more even photoresist etch rate and higher photoresist selectivity across the surface of the wafer. In addition, it is believed the fluorine content of the polymer-forming radicals created from the CHF₃ is more uniform throughout the plasma than similar radicals produced from the C₂F₆ etchant gas, thereby further ensuring a more uniform etch rate. However, it was also observed that the etch depth for .35 to .4 µm diameter contact vias (i.e., small contacts) was not as good as when using C₂F₆ in the etchant gas. In run 2-2, the chamber pressure was increased to 30 mT. The photoresist etch rate uniformity, as well as the selectivity of the etchant for the photoresist layer, improved further as was expected due the corresponding increase in the radical-to-ion ratio of the plasma. It was also observed that the counteracting effect of the plasma on the DC wafer bias was much less pronounced in both runs. In fact, it was so weak that the effect is not considered be a problem when using the second preferred embodiment of the invention. Accordingly, the second embodiment has the advantage of providing a substantial improvement in photoresist etch rate uniformity and selective, without the detrimental effects of a reduced DC wafer bias or the necessity of increasing the DC bias (perhaps beyond the capability of the etch reactor employed). However, a limited etch depth was still observed for small contact vias, in comparison to that obtainable with the first embodiment. Thus, the second embodiment presents a trade off, i.e. an improved photoresist uniformity and selectivity is achieved, but at the expense of etch depth in small contact vias.

Runs 2-3 and 2-4 demonstrate the previously-described etch stopping problem which occurs when the combined values of the chamber pressure and fluorine-containing etchant component flow rate are increased too much. Although the photoresist etch uniformity and selectivity was good in both runs, etch stop was observed at a depth of only 1 µm for small features (i.e. contacts with 0.4 µm diameter). Run 2-4 further demonstrated that increasing the flow rate of the diluent component of the etchant gas (i.e. helium), does not eliminate the etch stop problem when the combined values of the chamber pressure and the flow rate of the fluorine-containing etchant component are excessive.

**TABLE 3**

| **RUN** | **C**_{**2**}**F**_{**6**} **(sccm)** | **CHF**_{**3**} **(sccm)** | **He (sccm)** | **Pressure (mT)** | **Results** |
|---|---|---|---|---|---|
| **3-1** | 40 | 20 | 100 | 60.00 | U&S- Best Etch Stop |
| **3-2** | 20 | 20 | 100 | 60.00 | U&S- Best |

The working examples of the third preferred embodiment of the present invention shown in Table 3 demonstrate how the limitation of small feature etch stop associated with the second embodiment can be reduced while obtaining a high selectivity and uniformity of photoresist etch. Essentially, this is accomplished by including both C₂F₆ and CHF₃ components in the etchant gas. Here again, the other process parameters used in combination with the conditions and mixtures identified in Table 3 were similar to those employed for Table 2, except that the RF bias power was increased to approximately 1800 watts. A results column is also included, as in Tables 1 and 2.

The run 3-1 exhibited the best photoresist etch selectivity and uniformity seen in the testing up to that time, but some small feature etch stopping was observed. This etch stop condition is believed to be caused by the high combined flow rate of the C₂F₆ and CHF₃ components. By reducing the total flow of C₂F₆ and CHF₃ as was done in run 3-2 to 20 sccm for both C₂F₆ and CHF₃ at a pressure of 60 millitorr, a good etch depth for small features was achieved, while at the same time the superior photoresist etch rate uniformity and selectivity was retained. In addition, the counteracting effect of the plasma on the DC wafer bias was not a significant problem.

However, it must be pointed out that the chamber pressure employed in the testing of the third embodiment (i.e. 60 mT) was greater than that employed in, for example, run 1-5 associated with the testing of the first embodiment and run 2-2 associated with the testing of the second embodiment (i.e. 30mT). It is believed that this increase in pressure was partially responsible for the improved uniformity and selectivity. The third embodiment is actually theorized to be essentially a compromise between the first and second embodiments. For example, had the pressure in run 3-2 been more in line with that of runs 1-5, and 2-2, it is believed the etch depth would not have been quite as good as that obtainable using the C₂F₆ and diluent etchant mixture of run 1-5, and the photoresist etch rate uniformity and selectivity would not have been quite as good as that obtainable using the CHF₃ and diluent mixture of run 2-2. Regardless, it is believe that in most etch processes, the etch depth produced by the third embodiment will be acceptable and the photoresist etch rate uniformity and selectivity will be sufficient to complete the process before any unwanted etching of the silicon dioxide layer at the periphery of the wafer.

If, however, the etch depth and photoresist etch characteristics produced by the third embodiment are not sufficient, the fourth embodiment of the present invention can be employed. Working examples of this fourth embodiment are shown in Table 4. Those process parameters used in combination with the conditions and mixtures identified in Table 4, but not shown, were similar to the parameters employed for the working examples of Table 2.

**TABLE 4**

| **RUN** | **BP (watts)** | **C**_{**2**}**F**_{**6**} **(sccm)** | **CHF**_{**3**} **(sccm)** | **He (sccm)** | **Pressure (mT)** |
|---|---|---|---|---|---|
| **4-1** | | | | | |
| **(5")** | 1200 | 10 | 58 | 100 | 40.00 |
| **(60")** | 1500 | | 58 | 100 | 60.00 |
| **(120")** | 1500 | 40 | | 100 | 30.00 |
| | | | | | |

| **4-2** | | | | | |
|---|---|---|---|---|---|
| **(5")** | 1800 | 10 | 58 | 100 | 40.00 |
| **(50")** | 1800 | | 40 | 100 | 60.00 |
| **(100")** | 1800 | 40 | | 100 | 30.00 |

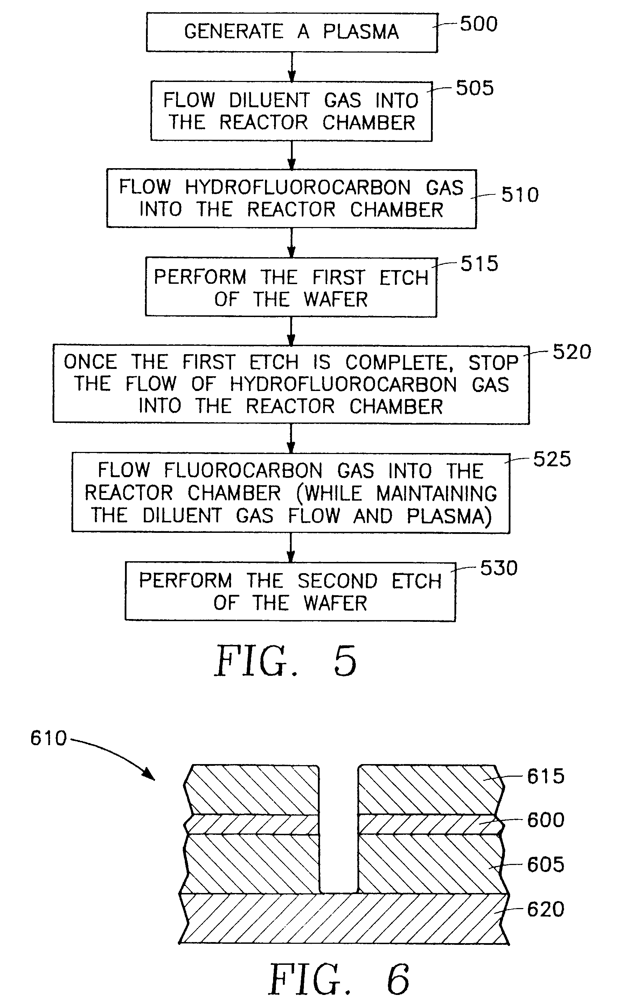

The fourth embodiment according to the present invention involves a multi-step etch process. As shown in FIG. 5, this multi-step etch process entails performing a first step 500 of generating a plasma within the reactor chamber. Typically, a plasma is struck by flowing argon gas into the chamber while applying power via electrodes or an antenna, but without applying a RF bias on the wafer. This same procedure can be employed in the present invention as well. The next step 505 entails flowing a hydrofluorocarbon component of the etchant gas into the chamber (CHF₃ in this case). In addition, as shown in step 510, a diluent (He in this case) is introduced into the chamber as well. If helium is used as the diluent gas, the argon used to ignite the plasma would be discontinued. However, if argon is used as the diluent gas, the flow rate of the argon used to ignite the plasma is simply adjusted to that required for the diluent gas. The wafer is next etched for appropriate period in step 515, as will be discussed below. Once the first etch step is complete, the flow of the hydrofluorocarbon component is stopped (step 520) and a fluorocarbon component (C₂F₆ in this case) is introduced in its stead (step 525). It is noted that the diluent is still flowing into the chamber and the plasma is being maintained. As shown in final step 530, the wafer is again etched for an appropriate period to complete the etching process.

Essentially, the first etch step of the above-described process involves using the CHF₃ and diluent etchant mixture associated with the second embodiment of the present invention, followed by a second etch step employing the C₂F₆ and diluent etchant mixture associated with the first embodiment. The first etch step provides what is believed to be the best photoresist etch uniformity and selectivity of any of the previously described embodiments, and at least some etch depth even in small features. This step also is responsible for depositing an even layer of polymer over the photoresist material. This polymer layer exhibits a good adhesion to the photoresist. The second step then provides the etch depth necessary to complete the etch process.

The second step will also exhibit a somewhat lower polymer deposition onto the photoresist in the peripheral region of the wafer than in the central region. This characteristic would usually result in a somewhat less uniform photoresist etch rate and lower selectivity when the first embodiment is employed alone. However, when employed as the second step of the present procedure, this undesirable characteristic is mitigated due to the presence of the polymer layer already deposited over the photoresist during the first etch step. As a result, the relative non-uniformity in photoresist etch rate usually produced with the first embodiment becomes insignificant. Given that the etch features are already partially formed in the first step, it is believed any reasonable etch depth can be achieved during the second step before the non-uniformity in the photoresist etch rate becomes a problem. Thus, this multi-step approach results in superior photoresist etch uniformity and selectivity, as well as excellent etch depth even in small features. In addition, no significant polymer peeling occurs. The fourth embodiment benefits from all the advantages of the other embodiments with none of the detriments. The only downside observed with this embodiment is that the multi-step approach is more complex to implement and likely to require more time. However, it is believed the superior results may justify any addition expense, especially when relatively large etch depths are required in small features.

It was also found that a stabilizing step in which an etchant gas enters the chamber at a high pressure (for example 30-60 mT) for a short time (for example 5 seconds) prior to performing the first and second etch step can be advantageous. The stabilization step relieves pressure in the mass flow controller or "MFC", which is used to control the flow rate in plasma reactors. This added step could also be employed with the other embodiments of the present invention, if desired.

The first run (i.e. 4-1) of Table 4 used a 5 second stabilizing step having a flow rate of 10 sccm of C₂F₆, 58 sccm CHF₃, and 100 sccm He at approximately 40 mT, and RF bias power was 1200 watts. This was followed by a first etch step for 60 seconds using 58 sccm CHF₃ and 100 sccm of He at approximately 60 mT with a RF bias power of 1500 watts, and a second etch step for 120 seconds using 40 sccm of C₂F₆ and 100 sccm of He at approximately 30 mT with a RF bias power of 1500 watts. This run exhibited excellent photoresist etch uniformity and selectivity, excellent small and large feature etch depth (e.g. a depth of approximately 1.6 µm in small features with a CD of about 0.4 µm), and no peeling of the polymer. In the second working example, run 4-2, the duration of the first and second etch step were reduced, as well as the flow rate of CHF₃ during the first etch step to 40 sccm. In addition, the 3RF bias power was increase to about 1800 watts. These conditions produced the same excellent results as the first run (4-1), but required less processing time. It is believed the increase in RF bias power facilitated the advantageous shortening of the process time. This being the case, an increased RF bias power could be employed in the other embodiments of the present invention, as well, to shorten the processing time.

It is also noted that in other testing using elevated RF bias levels (e.g. about 1500-2000 watts) it was discovered that the photoresist etch selectivity increased when a higher RF bias was employed in those processes using CHF₃ alone as the etchant gas. It is theorized that the improved selectivity relates to the lower molecular weight of CHF₃ in comparison to C₂F₆. At higher RF bias levels the etchant gas ions impact the wafer with more momentum. However, the photoresist layer is somewhat more impervious to this bombardment than is the oxide layer of the wafer. It is believed that the increased momentum of the CHF₃ ions is enough to increase the etching rate of the oxide layer, but still too low too significantly increase the etching rate of the photoresist layer. Thus, the effective selectivity is increased. However, in the case of C₂F₆ the greater molecular weight causes an increase in the etching rates of both the oxide and the photoresist layers. Thus, an improved selectivity is not realized. Accordingly, it is preferred that when CHF₃ alone is used in conjunction with one of the embodiments of the present invention, a higher RF bias be employed. Specifically, the increased bias should be within the range between about 1500 to 2000 watts, and preferably in excess of 1800 watts.

The embodiments of the present invention can be applied with particular advantage in a type of lithography process used especially for etching very small features. As shown in FIG. 6, in order to etch very small features (for example features having a diameter or smaller dimension of less than approximately 0.4 µm), a layer 600 of an anti-reflective coating ("ARC"), is first deposited on a silicon dioxide layer 605 of a wafer 610. ARC materials used for this purpose are organic mixtures that reduce substrate reflectivity phenomena, for example ARC ® CD11-1100 made by Brewer Science, Inc. of Rolla, Missouri. A deep ultra violet, or DUV, photoresist layer 615 is then deposited on top of the ARC layer 600. Conventional masking and development steps are then used to produce a desired pattern of features by removing portions of the DUV layer 615. However, these steps do not remove any of the ARC layer 600 covering the features to be etched.

An ARC layer etch is then performed to remove the ARC layer 600 covering the features to be etched. The ARC layer etch may be accomplished by at least two conventional processes. One process uses an etchant gas of pure O₂ and a non-reactive gas such as argon, helium, or nitrogen. This method removes only the ARC layer material on the features of interest. Another method uses a mixture of a fluorine-containing gas, O₂, and Ar or He, as an etchant gas. This method etches through the ARC layer and also etches some of the silicon dioxide in the feature.

Either of these ARC layer etches is followed by a so-called "main" etch to provide the deep etching of the silicon dioxide in the feature that is required for the semiconductor device being fabricated. The embodiments of the present invention provide a substantial improvement when used in conjunction with the main etch. The improvement results because additional protection is provided to the portions of the silicon dioxide that remain covered by the DUV photoresist layer 615 and ARC layer 600 due to the high selectivity the previously-disclosed embodiments of the present invention would exhibit for these layers in comparison to the oxide layer. In addition, a high selectivity would also be exhibited for the barrier layer 620 once exposed.

Specifically, the processes of the present invention exhibit a very high etch selectivity to the ARC layer 600 on the order of 20:1, and to a lesser extent to the DUV photoresist layer 615, i.e. on the order of 5 to 1 measured at the bottom of the faceting angle. Thus, if the DUV photoresist layer 410 is eventually etched away during the silicon dioxide etch, which may not even occur using the processes of the present invention, the masked portions of the silicon dioxide will still be protected by the ARC layer 600. Typical prior art processes do not exhibit the high selectivity for DUV and ARC layer that the processes of the present invention provide. Thus, punchthrough of the ARC layer is more likely using the prior processes. This possibility has been all but eliminated due to the high selectivity associated with the present invention. The net result is that the photoresist layer can be employed for patterning purposes, which is a much easier method when smaller geometries are involved than any other conventional patterning method.

Use of the present invention also produces etched features with straight sides as shown in FIG. 6, without substantial faceting or depressions in the barrier layer, for the reasons disclosed previously.

A working example of this application is shown in Table 5.

**TABLE 5**

| | **BP (w)** | **C**_{**2**}**F**_{**6**} **(sccm)** | **CHF**_{**3**} **(sccm)** | **He (sccm)** | **P (mT)** | **Etch Time** |
|---|---|---|---|---|---|---|
| **Main Etch** | 1800 | 20 | 15 | 100 | 60 | 180 |

In this example, the features examined had diameters or smaller dimensions of approximately 0.35 µm, and the other process parameters not listed in the table were similar to those employed in the examples of Table 2.

The main etch in this working example used a version of the third preferred embodiment according to the present invention, which consisted of an etchant gas composed of 20 sccm of C₂F₆, 15 sccm CHF₃, and 100 sccm He at a chamber pressure of 60 millitorr. These etch conditions maintained all the benefits of the invention, such as good photoresist etch uniformity and selectivity without polymer peeling, and accomplished the additional object of greatly increased selectivity for the ARC layer. As a result, in the small features described earlier (i.e., approximately 0.35 µm), etch depths in silicon dioxide of 1.8 µm were achieved with no faceting of the feature walls.

Although the present invention has been described with reference to preferred embodiments, workers skilled in the art will recognize that changes may be made in form and detail without departing from the spirit and scope of the invention.

## Claims

1. A plasma etch process for etching a workpiece in a processing chamber, the process comprising the steps of:
introducing a production workpiece into the chamber;
igniting a plasma within the chamber;
flowing a first fluorine-containing component of an etchant gas into the chamber, said first fluorine-containing component consisting of a hydrofluorocarbon gas;
stopping the flow of the first fluorine-containing component; and then
flowing a second fluorine-containing component of an etchant gas into the chamber, said second fluorine-containing component consisting of a fluorocarbon gas.

2. A process as claimed in claim 1 further comprising the step of:
flowing a diluent component of the etchant gas into the chamber along with the first fluorine-containing component or flowing a diluent component of the etchant gas into the chamber along with the second fluorine-containing component.

3. A process as claimed in claim 2 further comprising the steps of:
prior to introducing the production workpiece into the chamber,
(a) igniting a plasma within the chamber,
(b) introducing the first fluorine-containing component of the etchant gas into the chamber,
(c) introducing the diluent component of the etchant gas into the chamber,
(d) fixing respective values of three process parameters chosen from a group consisting of (i) a flow rate of the fluorine-containing component, (ii) chamber pressure, (iii) a power level of the power source, and (iv) a temperature of the chamber roof,
(e) selecting a value for the remaining process parameter from said group,
(f) etching a test workpiece placed into the chamber,
(g) upon completion of the test workpiece etching, determining if the workpiece exhibits certain first desired characteristics associated with the use of the first fluorine-containing component of the etchant gas,
(h) repeating steps (e) through (g) using a new test workpiece each time until one of the test workpieces exhibits the first desired characteristics,
(i) introducing the second fluorine-containing component of the etchant gas into the chamber,
(j) fixing respective values of three process parameters chosen from a group consisting of (i) the flow rate of the fluorine-containing component, (ii) chamber pressure, (iii) the power level of the power source, and (iv) the temperature of the chamber roof,
(k) selecting a value for the remaining process parameter from said group,
(l) etching a test workpiece placed into the chamber,
(m) upon completion of the test workpiece etching, determining if the workpiece exhibits certain second desired characteristics associated with the use of the second fluorine-containing component of the etchant gas, and
(n) repeating steps (k) through (m) using a new test workpiece each time until one of the test workpieces exhibits the second desired characteristics; and
performing the plasma etch process using the respective fixed values of the chosen process parameters and the value of the remaining process parameter which were determined to produce, the first desired characteristics whenever the first fluorine-containing component of the etchant gas is employed, and the second desired characteristics whenever the second fluorine-containing component of the etchant gas is employed.

4. A process as claimed in claim 3 further comprising the steps of:
modifying the value of at least one of the three fixed process parameters whenever said first desired characteristics are not exhibited regardless of what value is selected for the remaining process parameter; and
repeating steps (e) through (h).

5. A process as claimed in claim 3 or claim 4 further comprising the steps of:
modifying the value of at least one of the three fixed process parameters whenever said second desired characteristics are not exhibited regardless of what value is selected for the remaining process parameter; and
repeating steps (k) through (n).

6. A process as claimed in any one of claims 3 to 5 wherein the remaining process parameter is one of (i) the chamber pressure, (ii) the flow rate of the fluorine-containing component, or (iii) the power level of the RF power source.

7. A process as claimed in any one of claims 3 to 6 wherein the first and second desired characteristics comprise a substantially uniform etch rate across a top surface of a photoresist layer covering a part of the workpiece, a high selectivity of the etchant gas for the photoresist layer in comparison to an underlying layer of the workpiece, a minimum occurrence of peeling of a polymer layer formed over the photoresist layer during the plasma etch process from the photoresist layer, and a minimization of etch stopping in any of those areas of the workpiece not covered by the photoresist layer.

8. A process as claimed in any one of claims 3 to 7 wherein the flow rate of the first fluorine-containing component and the second fluorine-containing component are each between about 15 sccm and about 80 sccm.

9. A process as claimed in claim 1 or claim 2 further comprising the step of following a stabilizing gas into the chamber prior to the step of flowing the first fluorine-containing component of an etchant gas into the chamber.

10. A process as claimed in claim 9 wherein the step of flowing a stabilizing gas into the chamber comprises:
flowing said stabilizing gas for a predetermined stabilization period in the range of approximately 1 to 10 seconds; and
maintaining the chamber at a pressure in a range of approximately 30 to 60 millitorr.

11. A process as claimed in claim 9 or claim 10 wherein the stabilizing gas comprises a mixture of a fluorocarbon gas and a hydrofluorocarbon gas.

12. A process as claimed in claim 1 or claim 2 wherein the step of flowing the first fluorine-containing component of the etchant gas into the chamber comprises flowing the first component for a predetermined period in the range of approximately 30 to 60 seconds and/or wherein the step of flowing the second fluorine-containing component of the etchant gas into the chamber comprises flowing the second component for a predetermined period in the range of approximately 80 to 160 seconds.

13. A plasma etch process for etching a workpiece in a processing chamber having a roof, the process comprising the steps of:
(a) igniting a plasma within the chamber,
(b) introducing a fluorine-containing component of an etchant gas into the chamber, said fluorine-containing component comprising at least one of a fluorocarbon gas and a hydrofluorocarbon gas;
(c) introducing a diluent component of the etchant gas into the chamber, said diluent component comprising an inert gas,
(d) fixing respective values of three process parameters chosen from a group consisting of (i) a flow rate of the fluorine-containing component, (ii) chamber pressure, (iii) a power level of an RF power source used to maintain the plasma, and (iv) a temperature of the chamber roof,
(e) selecting a value for the remaining process parameter from said group,
(f) etching a test workpiece placed into the chamber,
(g) upon completion of the test workpiece etching, determining if the workpiece exhibits certain desired characteristics; and
(h) repeating steps (e) through (g) using a new test workpiece each time until one of the test workpieces exhibits the desired characteristics.

14. A process as claimed in claim 13 further comprising the steps of:
modifying the value of at least one of the three fixed process parameters whenever said desired characteristics are not exhibited regardless of what value is selected for the remaining process parameter; and
repeating steps (e) through (h).

15. A process as claimed in claim 13 or claim 14 further comprising the steps of:
upon determining the test workpiece exhibits the desired characteristics,
placing a production workpiece into the chamber,
introducing the fluorine-containing component of an etchant gas into the chamber,
introducing the diluent component of the etchant gas into the chamber, and
performing the plasma etch process using the fixed values of the chosen process parameters and the value of the remaining process parameter which was determined to produce the desired characteristics.

16. A process as claimed in any one of claims 13 to 15 wherein the remaining process parameter is the flow rate of the fluorine-containing component, or wherein the remaining process parameter is the chamber pressure whenever it is not desired to employ the flow rate of the fluorine-containing component as the remaining process parameter and a maximum etch depth is not one of the desired characteristics, or wherein the remaining process parameter is the power level of the RF power source whenever it is not desired to employ the flow rate of the fluorine-containing component as the remaining process parameter and a maximum etch depth is one of the desired characteristics.

17. A process as claimed in any one of claims 13 to 16 wherein the desired characteristics comprise a substantially uniform etch rate across a top surface of a photoresist layer covering a part of the workpiece, a high selectivity of the etchant gas for the photoresist layer in comparison to an underlying layer of the workpiece, a minimum occurrence of peeling of a polymer layer formed over the photoresist layer during the plasma etch process from the photoresist layer, and a minimization of etch stopping in any of those areas of the workpiece not covered by the photoresist layer.

18. A process as claimed in any one of claims 13 to 17 wherein the flow rate of the fluorine-containing component of the etchant gas is between about 15 sccm and about 80 sccm.

19. A process as claimed in any one of the preceding claims wherein the chamber pressure level is between about 4 millitorr and about 60 millitorr.

20. A process as claimed in any one of claims 3 to 19 wherein the diluent component of the etchant gas comprises an inert gas and/or a noble gas.

21. A process as claimed in claim 20 wherein the nobel gas comprises at least one of helium and argon.

22. A process as claimed in any one of claims 3 to 21 wherein the flow rate of the diluent component of the etchant gas is chosen so as to minimize etch stopping during the plasma etch process.

23. A process as claimed in any one of claims 3 to 22 wherein a flow rate of the diluent component of the etchant gas is between about 50 sccm and about 400 sccm.

24. A process as claimed in any one of claims 3 to 23 wherein the power level of the RF power source is between about 1200 watts and about 3000 watts.

25. A process as claimed in any one of claims 3 to 24 wherein the temperature of the chamber roof is between about 180 degrees Centigrade and about 300 degrees Centigrade.

26. A process as claimed in any one of the preceding claims wherein the fluorocarbon gas comprises C₂F₆ and/or wherein the hydrofluorocarbon gas comprises CHF₃.

27. A process as claimed in claim 26 further comprising the step of imposing a RF bias on the workpiece to enhance the etching thereof, wherein said RF bias is created by a RF bias power source producing power in a range between approximately 1500 watts and approximately 2000 watts.

28. A process as claimed in claim 27 wherein the RF bias power source produces power in excess of approximately 1800 watts.

29. A process as claimed in any one of claims 13 to 28 wherein the fluorine-containing component of an etchant gas comprises both a fluorocarbon gas and a hydrofluorocarbon gas in approximately equal proportions.

30. A process as claimed in any one of the preceding claims wherein said workpiece comprises a semiconductor wafer having a layer of oxygen-containing material with an underlying layer of non-oxygen-containing material, and a layer of photoresist material overlying portions of the oxygen-containing layer.

31. A process as claimed in any one of claims 1 to 29 wherein said workpiece comprises a semiconductor wafer having a plurality of layers a bottom-most of which is comprised of a non-oxygen-containing material followed by successive overlying layers respectively comprising an oxygen-containing material, an anti-reflective material, and photoresist material.

32. A process as claimed in claim 31 wherein the anti-reflective layer is comprised of an organic solution composed substantially of cyclohexanone, and the photoresist layer is comprised of an organic solution composed substantially of a deep ultraviolet photoresist material.
